**Europäisches Patentamt**

**European Patent Office**

**Office européen des brevets**

(11) Numéro de publication: **0 226 476**
**B1**

(12) **FASCICULE DE BREVET EUROPEEN**

(45) Date de publication du fascicule du brevet:
**27.12.90**

(21) Numéro de dépôt: **86402121.7**

(22) Date de dépôt: **29.09.86**

(51) Int. Cl.⁵: **G01R 15/06**

(54) Dispositif de mesure de tension d'une installation blindée haute tension.

(30) Priorité: **14.10.85 FR 8515301**

(43) Date de publication de la demande:
**24.06.87 Bulletin 87/26**

(45) Mention de la délivrance du brevet:
**27.12.90 Bulletin 90/52**

(84) Etats contractants désignés:
**AT BE CH DE GB IT LI SE**

(56) Documents cités:
**DE-A- 2 313 401**
**DE-A- 3 243 342**

(73) Titulaire: **MERLIN GERIN, Rue Henri Tarze,**
**F-38050 Grenoble Cédex(FR)**

(72) Inventeur: **Henry, Georges, Merlin Gerin,**
**F-38050 Grenoble Cedex(FR)**
Inventeur: **Girard, Robert, Merlin Gerin,**
**F-38050 Grenoble Cedex(FR)**
Inventeur: **Kieffer, Jean, Merlin Gerin, F-38050 Grenoble**
**Cedex(FR)**

(74) Mandataire: **Kern, Paul et al, Merlin Gerin Sce.**
**Brevets 20, rue Henri Tarze, F-38050 Grenoble**
**Cédex(FR)**

## Description

L'invention est relative à un dispositif de mesure de la tension d'un conducteur haute tension, disposé dans une enceinte étanche remplie d'un gaz à rigidité diélectrique élevée, notamment d'une installation blindée haute tension, comprenant un diviseur capacitif constitué par un condensateur haute tension, et un condensateur basse tension connectés en série, le condensateur haute tension étant disposé dans ladite enceinte et comprenant ledit conducteur et une électrode entourant ledit conducteur et le condensateur basse tension étant disposé dans un compartiment étanche à l'extérieur de ladite enceinte en étant relié électriquement à ladite électrode par un conducteur traversant la paroi de l'enceinte, le compartiment étanche et l'enceinte communiquant par un orifice de communication.

Le document DE-A 3 243 342 décrit un dispositif de mesure du genre mentionné qui comporte un condensateur basse tension disposé dans un compartiment communiquant en permanence avec l'enceinte de l'installation blindée. On s'affranchit ainsi des imprécisions dues aux variations de température et de pression, lesquelles influencent en même temps le condensateur haute tension et le condensateur basse tension disposés dans le même volume gazeux. Le condensateur basse tension est un élément fragile et une intervention ou réparation peut s'imposer périodiquement. Dans ce cas, l'ensemble de l'installation doit être mis hors circuit et vidé pour donner accès à ce condensateur basse tension. Ces opérations de vidange, qui nécessitent par la suite une remise sous vide et un remplissage à l'hexafluorure de soufre, sont délicates et compliquées.

Le but de la présente invention est de permettre la réalisation d'un dispositif de mesure à diviseur capacitif permettant un accès aisé au condensateur basse tension tout en évitant les variations dues à la température ou à la pression du gaz de l'installation.

Le dispositif de mesure selon l'invention est caractérisé en ce que le compartiment étanche du condensateur basse tension comprend un orifice de remplissage de gaz et que l'orifice de communication et l'orifice de remplissage sont munis de clapets pour la mise en communication dudit compartiment sélectivement avec l'enceinte et avec un conduit de remplissage connecté à l'orifice de remplissage.

En fonctionnement normal, le compartiment de logement du condensateur basse tension est en communication permanente avec l'enceinte contenant le condensateur haute tension du diviseur capacitif et toute variation de pression et/ou de température est automatiquement transmise au compartiment, de manière à éviter toute influence sur la mesure. Le logement dans un compartiment séparé permet d'isoler ce dernier de l'enceinte de l'installation par simple fermeture d'un clapet associé à l'orifice de communication pour permettre une intervention dans ce compartiment. Par la suite, il convient bien entendu de faire le vide dans ce compartiment avant de le remettre en communication avec l'enceinte mais cette intervention est limitée et nettement plus simple que l'opération visant le remplissage complet de l'enceinte. Les quantités de gaz manipulées sont notablement inférieures et les risques de fuites ou de pollution sont notablement réduits.

Le logement dans un compartiment séparé du condensateur basse tension permet d'incorporer dans ce logement d'autres éléments du dispositif de mesure.

Afin d'éviter toute fausse manœuvre, le clapet de l'orifice de communication est sollicité en position de fermeture, la commande d'ouverture étant actionnée par la mise en place d'un capot d'obturation de l'orifice de remplissage. On est ainsi assuré d'une fermeture étanche du compartiment avant sa mise en communication avec l'enceinte de l'installation blindée. L'enlèvement du capot obturateur provoque inversement la fermeture automatique du clapet de l'orifice de communication ainsi d'ailleurs que le démontage du couvercle d'accès au compartiment. La commande du clapet de l'orifice de communication comporte avantageusement une tige coulissante qui coopère avec un poussoir traversant d'une manière étanche le couvercle du compartiment. Le capot obturateur est agencé pour engager en fin de course d'obturation la partie externe du poussoir et déplacer ce dernier dans la direction d'ouverture du clapet de l'orifice de communication. La mise en place d'un conduit de remplissage sur le coupleur associé à l'orifice de remplissage n'actionne pas le poussoir précité de façon à permettre une vidange et un remplissage du compartiment, ce dernier restant isolé de l'enceinte. Le coupleur de l'orifice de remplissage comporte avantageusement un clapet d'obturation sollicité en position de fermeture et déplacé en position d'ouverture par la connexion du conduit de remplissage. Cette disposition évite toute fuite au cours des manoeuvres de connexion et de déconnexion et de mise en place de l'obturateur de l'orifice de remplissage.

Le condensateur basse tension peut être d'un type quelconque d'une capacité variant avec la température de la même façon que celle du condensateur haute tension.

D'autres avantages et caractéristiques ressortiront plus clairement de la description qui va suivre d'un mode de mise en oeuvre de l'invention, donné à titre d'exemple non limitatif et représenté aux dessins annexés, dans lesquels :

- la figure 1 est une vue schématique en coupe axiale d'un dispositif de mesure selon l'invention, représenté en position normale de fonctionnement ;
- la figure 2 est une vue analogue à celle de la figure 1, montrant le dispositif de mesure pendant la phase de vidange du compartiment de logement du condensateur basse tension.

Sur les figures, une enceinte 10 d'une installation blindée à haute tension est remplie d'un gaz à rigidité diélectrique élevée, par exemple de l'hexafluorure de soufre sous pression ($SF_6$). Dans l'exemple représenté sur les figures, l'enveloppe 12 de l'enceinte 10 est cylindrique et entoure coaxialement un conducteur 14, par exemple une barre sous haute tension. Entre l'enveloppe 12 et la barre 14 est intercalée une électrode cylindrique 16 qui constitue avec la barre 14 un condensateur haute tension dont le diélectrique est le SF$_6$. A l'extérieur de l'enveloppe 12 est fixé un embout 18 qui confine un compartiment étanche 20. Dans la paroi 22 de séparation du compartiment 20 de l'enceinte 10 sont fixés deux coupleurs 24 présentant chacun un orifice de communication 26, susceptibles d'être obturés par un clapet 28, sollicité en position de fermeture par un ressort 30. L'embout 18 est fermé du côté opposé à la paroi 22 par un couvercle 32, maintenu par des vis de serrage 34 avec interposition de joints d'étanchéité non représentés. Dans le compartiment 20 est logé un condensateur basse tension 36, dont l'une 38 des électrodes est connectée à la terre, par exemple à la paroi métallique de l'embout 18 et dont l'autre électrode 40 est connectée d'une part par un conducteur 42 traversant d'une manière étanche la paroi 22 à l'électrode cylindrique 16 du condensateur haute tension et d'autre part par un conducteur 44 traversant la paroi de l'embout 18 à un appareil de mesure 46. Il est facile de voir que la connexion en série du condensateur haute tension 14, 16 et du condensateur basse tension 38, 40, constitue un diviseur capacitif bien connu des spécialistes permettant une mesure de la tension du conducteur 14. Il est inutile de décrire en détails de tels diviseurs capacitifs, notamment l'appareil de mesure 46 qui peut être d'un type quelconque.

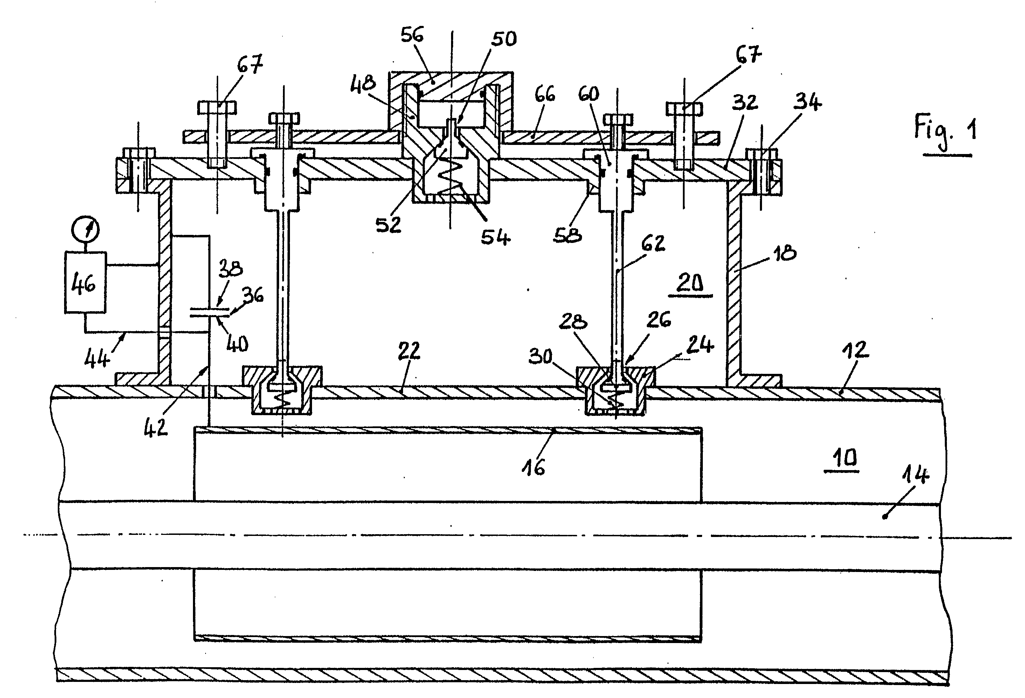

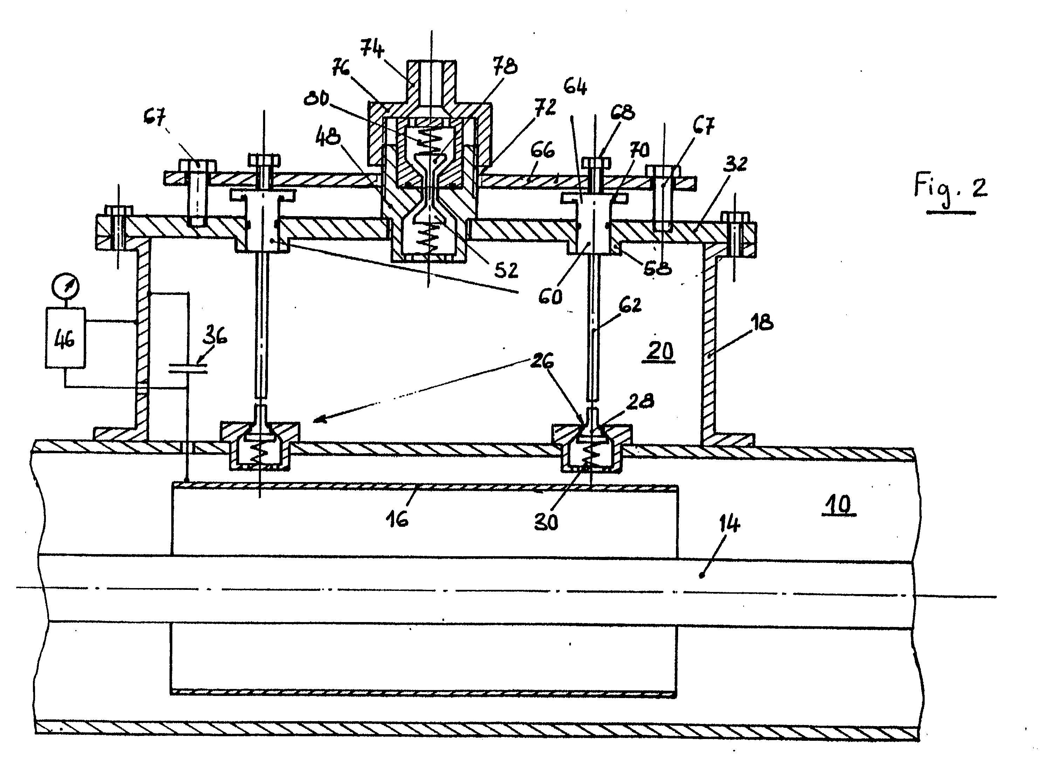

Le couvercle 32 porte un coupleur 48 présentant un orifice de remplissage 50, équipé d'un clapet 52, sollicité en position de fermeture par un ressort 54. Sur le coupleur 48 peut être fixé, par exemple par vissage, un capot obturateur 56 assurant une double étanchéité, ainsi que la commande du clapet 28 de la manière décrite ci-dessous. Seule la commande de l'un des clapets 28 est décrite, l'autre étant identique. Le couvercle 32 porte un manchon de guidage 58 disposé en regard du clapet 28 de l'orifice de communication 26. Dans le manchon 58 est monté à coulissement étanche un poussoir 60 portant sur sa partie interne au compartiment 20 une tige de commande 62 dont l'extrémité libre coopère avec le clapet 28 de l'orifice de communication. La tête 64 du poussoir 60, disposée à l'extérieur du compartiment 20 coopère avec une plaque 66, susceptible d'un déplacement, limité par des vis de guidage 67, dans la direction de coulissement du poussoir 60. Une vis de réglage 68, est intercalée entre la tête 64 du poussoir 60 et la plaque mobile 66. En position d'écartement de la plaque 66 du couvercle 32, représentée la figure 2, le poussoir 60 est en position relevée et le clapet 28 est en position de fermeture de l'orifice de communication 26. En position rapprochée de la plaque 66 du couvercle 32, représentée à la figure 1, le poussoir 60 enfoncé actionne par sa tige 62 le clapet 28 vers la position d'ouverture de l'orifice de communication 26. La tête 64 porte un anneau torique d'étanchéité 70 venant s'appliquer sur le couvercle 32 en position enfoncée du poussoir 60 pour assurer une double étanchéité du compartiment 20. La plaque mobile 66 présente une ouverture 72 traversée par le coupleur 48.

En se référant à la figure 1, on voit que lors de la mise en place du capot obturateur 56 sur le coupleur 48, le bord de ce capot 56 engage la plaque mobile 66 et pousse cette dernière en position rapprochée du couvercle 32 provoquant l'ouverture du clapet de communication 28. L'enlèvement du capot obturateur 56 autorise par contre un écartement de la plaque mobile 66 du couvercle 32 sous l'action du ressort de rappel 30 du clapet 28 et une fermeture de ce dernier. Après enlèvement du capot obturateur 56, on peut fixer, par exemple par vissage ou clipsage sur le coupleur 48, un connecteur 76 d'un conduit de remplissage 74. Le connecteur 76 est équipé d'un clapet d'obturation 78, sollicité en position de fermeture par un ressort 80 et agencé pour coopérer avec le clapet 52 pour libérer la communication lors de la mise en place du conduit de remplissage 74. De tels coupleurs à obturation automatique lors d'une déconnexion et inversement à ouverture automatique de la communication lors d'une connexion sont bien connus des spécialistes. Le connecteur 76 est agencé pour ne pas actionner la plaque mobile 66 pendant la manoeuvre de connexion afin d'éviter toute ouverture intempestive du clapet 28 de l'orifice de communication 26.

Le dispositif de mesure selon l'invention fonctionne de la manière suivante :

- dans la position de fonctionnement normal, le coupleur 48 est coiffé par le capot obturateur 56 poussant la plaque mobile 66 en direction d'ouverture des clapets 28 des orifices de communication 26. Dans cette position représentée à la figure 1, le compartiment 20 est en communication avec l'enceinte 10, l'étanchéité du compartiment 20 vers l'extérieur étant assurée au niveau du coupleur 48, d'une part par le clapet 52 fermé et d'autre part par le capot obturateur 56. Les poussoirs enfoncés 60 comportent également une double étanchéité limitant les risques de fuites. Les communications assurées par les orifices 26 évitent toute différence de pression ou de température entre le compartiment 20 et l'enceinte 10 et la mesure du diviseur capacitif 14, 16, n'est pas affectée par de telles variations de température ou de pression, si l'on choisit un condensateur 36 variant avec la température de la même façon que le condensateur 14, 16.

- lors d'un incident, par exemple d'une défaillance du condensateur basse tension 36, on enlève le capot obturateur 56 qui libère la plaque mobile 66 venant en position écartée permettant la fermeture des clapets 28 des orifices de communication 26. Par la suite, on met en place le conduit de remplissage 74 de la manière représentée à la figure 2. La connexion du conduit de remplissage 74 provoque l'ouverture du clapet 52 de l'orifice de remplissage 50, les clapets 28 des orifices de communication 26 restant fermés Le gaz du compartiment 20 peut être évacué par le conduit de remplissage 74 en étant, soit récupéré, soit rejeté dans l'atmosphère. Après vidange du compartiment 20, le couvercle 32 peut être enlevé par dévissage des vis 34 pour donner accès au condensateur 36. Le remplissage de l'enceinte 10 est conservé pendant cette opération et l'installation peut éventuellement rester sous tension si l'on prend certaines précautions. La réparation étant effectuée, il suffit de refixer le couvercle 32 et de mettre sous vide et par la suite remplir de gaz le compartiment 20. Cette opération étant terminée, le conduit de remplissage 74 est déconnecté avec fermeture automatique du clapet 52 de l'orifice de remplissage 50. La mise en place du capot obturateur 56 provoque à nouveau l'ouverture des clapets 28 des orifices de communication 26 mettant l'installation dans la position d'origine, illustrée par la figure 1. Un démontage intempestif du couvercle 32, le capot obturateur 56 étant encore en place, provoque également la fermeture des clapets 28 des orifices de communication 26 limitant l'échappement de gaz de l'enceinte 10.

Il est clair qu'on ne sortirait pas du cadre de l'invention en prévoyant une commande manuelle du clapet 28 de l'orifice communication 26, la commande automatique ayant pour avantage d'éviter toute fausse manoeuvre et des consignes astreignantes. Le conduit de remplissage peut dans ce cas être fixé en permanence, tout autre type de coupleur pouvant d'ailleurs être utilisé.

## Revendications

1. Dispositif de mesure de la tension d'un conducteur (14) haute tension, disposé dans une enceinte (10) étanche remplie d'un gaz à rigidité diélectrique élevée, notamment d'une installation blindée haute tension, comprenant un diviseur capacitif constitué par un condensateur haute tension (14, 16), et un condensateur basse tension (36) connectés en série, le condensateur haute tension (14, 16) étant disposé dans ladite enceinte (10) et comprenant ledit conducteur (14) et une électrode (16) entourant ledit conducteur (14) et le condensateur basse tension (36) étant disposé dans un compartiment étanche (20) à l'extérieur de ladite enceinte en étant relié électriquement à ladite électrode (16) par un conducteur (42) traversant la paroi (22) de l'enceinte (10), le compartiment étanche (20) et l'enceinte (10) communiquant par un orifice (26) de communication, caractérisé en ce que le compartiment (20) étanche du condensateur basse tension (36) comprend un orifice (50) de remplissage de gaz et que l'orifice (26) de communication et l'orifice (50) de remplissage sont munis de clapets (28, 52) pour la mise en communication dudit compartiment (20) sélectivement avec l'enceinte (10) et avec un conduit de remplissage (74) connecté à l'orifice (50) de remplissage.

2. Dispositif de mesure selon la revendication 1, caractérisé en ce que ledit compartiment (20) est adjacent à ladite enceinte (10), l'orifice (26) de communication étant ménagé dans la paroi (22) de séparation du compartiment (20) et de l'enceinte (10).

3. Dispositif de mesure selon la revendication 1 ou 2, caractérisé en ce que ledit compartiment (20) comporte un couvercle (32) amovible donnant accès au condensateur basse tension (36) après enlèvement.

4. Dispositif de mesure selon la revendication 1, 2 ou 3, caractérisé en ce que le clapet (28) de l'orifice (26) de communication présente une commande (60, 66) d'ouverture actionnée par la mise en place d'un capot obturateur (56) sur l'orifice (50) de remplissage.

5. Dispositif de mesure selon la revendication 3 et 4, caractérisé en ce que ladite commande (60, 66) d'ouverture est inhibée par l'enlèvement dudit couvercle (32).

6. Dispositif de mesure selon l'une quelconque des revendications précédentes, caractérisé en ce que le clapet (52) de l'orifice (50) de remplissage est actionné en position d'ouverture par la connexion du conduit de remplissage (74) sur l'orifice (50) de remplissage et inversement en position de fermeture lors de la déconnexion dudit conduit de remplissage.

7. Dispositif de mesure selon l'une quelconque des revendications précédentes, caractérisé en ce que le clapet (28) de l'orifice (26) de communication est actionné par une tige (62) coulissante en appui d'un poussoir (60) traversant d'une manière étanche le couvercle (32) dudit compartiment (20), la partie externe (64) dudit poussoir étant déplacé automatiquement dans la direction d'ouverture par le mouvement de mise en place du capot obturateur (56) sur l'orifice (50) de remplissage.

8. Dispositif de mesure selon la revendication 7, caractérisé en ce que ledit poussoir (60) présente une double étanchéité dans la position active de commande d'ouverture du clapet (28) de l'orifice (26) de communication.

## Claims

1. A voltage measuring device of a high voltage conductor (14) housed in a sealed enclosure (10) filled with a high dielectric strength gas, notably of a metalclad installation, comprising a capacitive divider formed by a high voltage capacitor (14, 16) and a low voltage capacitor (36) connected in series, the high voltage capacitor (14, 16) being housed in said enclosure (10) and comprising said conductor (14) and an electrode (16) surrounding said conductor (14) and the low voltage capacitor (36) being located in a sealed compartment (20) outside said enclosure, and being electrically connected to said electrode (16) by a conductor (42) passing through the wall (22) of the enclosure (10), the sealed compartment (20) and the enclosure (10) communicating by means of a communication orifice (26), characterized in that the sealed compartment (20) of the low voltage capacitor (36) comprises a gas filling orifice (50) and that the communication orifice (26) and the filling orifice (50) are fitted with valves (28, 52) for said compartment (20) to communicate selectively with the enclosure (10) and a filling duct (74) connected to the filling orifice (50).

2. A measuring device according to claim 1, characterized in that said compartment (20) is adjacent to said enclosure (10), the communication orifice (26) being located in the wall (22) separating the compartment (20) from the enclosure (10).

3. A measuring device according to claim 1 or 2, characterized in that said compartment (20) has a removable cover (32) giving access to the low voltage capacitor (36) when removed.

4. A measuring device according to claim 1, 2 or 3, characterized in that the valve (28) of the communication orifice (26) has an opening mechanism (60, 66) actuated by the fitting of a sealing cap (56) on the filling orifice (50).

5. A measuring device according to claim 3 or 4, characterized in that said opening mechanism (60, 66) is inactive when said cover (32) is removed.

6. A measuring device according to anyone of the preceding claims, characterized in that the valve (52) of the filling orifice (50) is actuated in the open position by the connection of the filling duct (74) on the filling orifice (50) and inversely in the closed position when disconnected from said filling duct.

7. A measuring device according to anyone of the preceding claims, characterized in that the valve (28) of the communication orifice (26) is actuated by a sliding stem (62) supporting a push-button (60) passing tightly through the cover (32) of said compartment (20), the external part (64) of said push-button being moved automatically in the opening direction by the fitting movement of the sealing cap (56) on the filling orifice (50).

8. A measuring device according to claim 7, characterized in that said push-button (60) provides a double sealing in the active opening control position of the valve (28) of the communication orifice (26).

**Patentansprüche**

1. Spannungsmeßvorrichtung eines Hochspannungsleiters (14), der in einem gasdichten Gehäuse (10) angeordnet ist, welches mit Gas von hoher dielektrischer Festigkeit gefüllt ist, insbesondere eine abgeschirmte Hochspannungseinrichtung mit einem kapazitiven Teiler, der von in Serie geschalteten Hochspannungskondensatoren (14, 16) und Niederspannungskondensator (36) gebildet wird, wobei der Hochspannungskondensator (14, 16) in dem genannten Gehäuse (10) angeordnet ist und den genannten Leiter (14) und eine den genannten Leiter (14) umgebende Elektrode (16) aufweist, und wobei der Niederspannungskondensator (36) in einem dichten Abteil (20) außerhalb des genannten Gehäuses angeordnet ist und elektrisch mit der genannten Elektrode (16) durch einen Leiter (42) verbunden ist, der die Wand (22) des Gehäuses (10) durchquert, und wobei das gasdichte Abteil (20) und das Gehäuse (10) durch eine Öffnung (26) in Verbindung stehen, dadurch gekennzeichnet, daß das dichte Abteil (20) des Niederspannungskondensators (36) eine Gaseinfüllöffnung (50) aufweist, und daß die Verbindungsöffnung (26) und die Einfüllöffnung (50) mit Ventilen (28, 52) versehen sind, um das genannte Abteil (20) wahlweise mit dem Gehäuse (10) und mit einem mit der Einfüllöffnung (50) verbundenen Einfüllrohr (74) in Verbindung zu bringen.

2. Meßvorrichtung gemäß Anspruch 1, dadurch gekennzeichnet, daß das genannte Abteil (20) neben dem genannten Gehäuse (10) liegt, wobei die Verbindungsöffnung (26) in der Trennwand (22) des Abteils (20) und des Gehäuses (10) vorgesehen ist.

3. Meßvorrichtung gemäß Anspruch 1 oder 2, dadurch gekennzeichnet, daß das genannte Abteil (20) einen abnehmbaren Deckel (32) aufweist, der nach Abnahme Zugang zu dem Niederspannungskondensator (36) gibt.

4. Meßvorrichtung gemäß Anspruch 1, 2 oder 3, dadurch gekennzeichnet, daß das Ventil (28) der Verbindungsöffnung (26) eine Öffnungssteuerung (60, 66) aufweist, die durch das Aufsetzen einer Verschlußkappe (56) auf die Einfüllöffnung (50) betätigt wird.

5. Meßvorrichtung gemäß Anspruch 3 und 4, dadurch gekennzeichnet, daß die genannte Öffnungssteuerung (60, 66) durch Abnahme des genannten Deckels (32) gesperrt wird.

6. Meßvorrichtung gemäß irgendeinem der vorhergehenden Ansprüche, dadurch gekennzeichnet, daß das Ventil (52) der Einfüllöffnung (50) in Öffnungsstellung durch die Verbindung des Einfüllrohres (74) mit der Einfüllöffnung (50) betätigt wird, und umgekehrt, in Schließstellung bei Abnehmen des genannten Einfüllrohres.

7. Meßvorrichtung gemäß irgendeinem der vorhergehenden Ansprüche, dadurch gekennzeichnet, daß das Ventil (28) der Verbindungsöffnung (26) von einer Gleitstange (62) betätigt wird, die gegen einen Schieber (60) drückt, der auf gasdichte Weise den Deckel (32) des genannten Abteils (20) durchquert, wobei das äußere Teil (64) des genannten Schiebers automatisch in die Öffnungsrichtung bewegt wird durch das Aufsetzen der Verschlußkappe (56) auf die Einfüllöffnung (50).

8. Meßvorrichtung gemäß Anspruch 7, dadurch gekennzeichnet, daß der genannte Schieber (60) in der aktiven Lage der Öffnungssteuerung des Ventils (28) der Verbindungsöffnung (26) eine doppelte Dichtheit aufweist.

Fig. 1

Fig. 2

EP 0 226 476 B1